# EUROPEAN PATENT SPECIFICATION

(11) **EP 3 349 555 B1**
(45) Date of publication and mention of the grant of the patent: **02.10.2019**
(21) Application number: 17197787.9
(22) Date of filing: 23.10.2017
(51) Int. Cl.: H05K 7/20

(54) **ELECTRONIC APPARATUS**
ELEKTRONISCHE VORRICHTUNG
APPAREIL ÉLECTRONIQUE

(30) Priority: 13.01.2017 JP 2017004356
(43) Date of publication of application: 18.07.2018
(73) Proprietor: Alpine Electronics, Inc., Tokyo (JP)
(72) Inventor: Sato, Makoto, Iwaki-city, Fukushima (JP); Kojima, Masami, Iwaki-city, Fukushima (JP); Kuroda, Kazuhiro, Iwaki-city, Fukushima (JP)
(74) Representative: Dolleymores

(56) References cited:
- JP-A- 2001 111 275
- US-A- 5 694 294
- US-A- 6 144 556
- US-A1- 2006 104 025
- US-A1- 2009 168 346

## Description

### Technical Field

The present invention relates to an electronic apparatus.

In general, an electronic apparatus embedded with a board mounted with electronic components is installed with a fan for cooling the internal space of the electronic apparatus by discharging warm air heated by heat dissipation from a heat sink thermally connected to the electronic components to the outside of the electronic apparatus (for example, see Patent Literatures 1 and 2 and the like).

### Citation List

### Patent Literature

Patent Literature 1: JP 2002-134968 A
Patent Literature 2: JP 2002-064167 A

However, as discussed in Patent Literature 1, if the air blowing using the fan is performed for the entire internal space of the electronic apparatus, it may fail to sufficiently blow the air to the heat sink necessitating concentrated air blowing. This makes it difficult to perform sufficient cooling.

In this regard, as discussed in Patent Literature 2, the concentrated air blowing can be implemented by dividing the internal space of the electronic apparatus into a heat dissipation space using the heat sink and a board-side space and performing the fan air blowing only for the heat dissipation space. However, in this case, since the air blowing is not performed for the board-side space, an electronic component not thermally connected to the heat sink is not cooled, and it is difficult to perform efficient cooling for the entire electronic apparatus.
In addition, JP2001111275A, US6144556A, US2006/10425A1, US5694294A and US2009/168346A1 disclose electronic apparatus with a fan.

In view of the aforementioned problems, an object of the present invention is to efficiently cool the internal space of the electronic apparatus.

According to the invention a partitioning wall plate that covers a board mounted with an electronic component and forms a first space along with the board; a cover member that covers the partitioning wall plate and forms a second space along with the partitioning wall plate; and a fan configured to blow air entering from the outside the first space toward the outside through the second space in a predetermined direction and the second space is provided with a thermal conductor thermally connected to an electronic component of the first space, and a flow guide for guiding the air blowing from the fan to the thermal conductor.

As a result, it is possible to efficiently perform both concentrated air blowing to a thermal conductor and complete ventilation of the internal space of the electronic apparatus, cool the electronic components thermally connected to the thermal conductor in a concentrated manner, and entirely cool even an electronic component not thermally connected to the thermal conductor.

Furthermore, according to an aspect, it is preferable that the fan blows the air entering from the outside to the first space to the outside through the second space. As a result, it is possible to blow the cooling air from an electronic component having a low temperature to an electronic component having a high temperature and improve heat exchange efficiency.

Furthermore, according to an aspect, it is preferable that the partitioning wall plate is formed integrally with the thermal conductor. As a result, it is possible to further improve cooling efficiency by diffusing the heat of the thermal conductor.

Furthermore, according to an aspect, it is preferable that the first space is provided with a plurality of first openings along an outer circumference of the board. As a result, it is possible to cool the entire board evenly.

Furthermore, according to an aspect, it is preferable that the partitioning wall plate is provided with a through-hole that allows the first and second spaces to communicate with each other, and the fan is installed to the through-hole. As a result, the fan is disposed far from the inlet of the first space and also far from the outlet of the second space. Therefore, it is possible to prevent a fan noise from leaking to the outside and promote silence.

Furthermore, according to an aspect, it is preferable that the partitioning wall plate has an extension wall that covers the plurality of first openings. As a result, it is possible to prevent intrusion of dust.

### Advantageous Effects of Invention

It is possible to efficiently cool the internal space of the electronic apparatus.

### Brief Description of Drawings

FIGS. 1A and 1B are diagrams schematically illustrating an exemplary cross-sectional configuration of an electronic apparatus according to a first embodiment.
FIG. 2 is a diagram illustrating an exemplary exterior configuration of the electronic apparatus according to the first embodiment.
FIG. 3 is a diagram illustrating a state in which an upper cover member is removed from the electronic apparatus according to the first embodiment.
FIG. 4 is a diagram illustrating a state in which an upper cover member and a heat sink are removed from the electronic apparatus according to the first embodiment.
FIGS. 5A to 5C are diagrams illustrating an exemplary fan.
FIGS. 6A and 6B are diagrams illustrating exemplary configurations of a printed circuit board and a heat sink in a first space.
FIG. 7 is a diagram illustrating an exemplary configuration of the heat sink in a second space.
FIGS. 8A and 8B are diagrams schematically illustrating a cross-sectional configuration of an electronic apparatus in a comparative example.
FIGS. 9A and 9B are diagrams schematically illustrating an exemplary cross-sectional configuration of an electronic apparatus according to a second embodiment.
FIGS. 10A and 10B are diagrams schematically illustrating an exemplary cross-sectional configuration of an electronic apparatus according to a third embodiment.

### Description of Embodiments

Each embodiment will now be described with reference to the accompanying drawings. Note that like reference numerals denote like elements having substantially the same functional configurations throughout the specification and the drawings, and they will not be described repeatedly.

### [First Embodiment]

### <Cross-sectional Configuration of Electronic Apparatus>

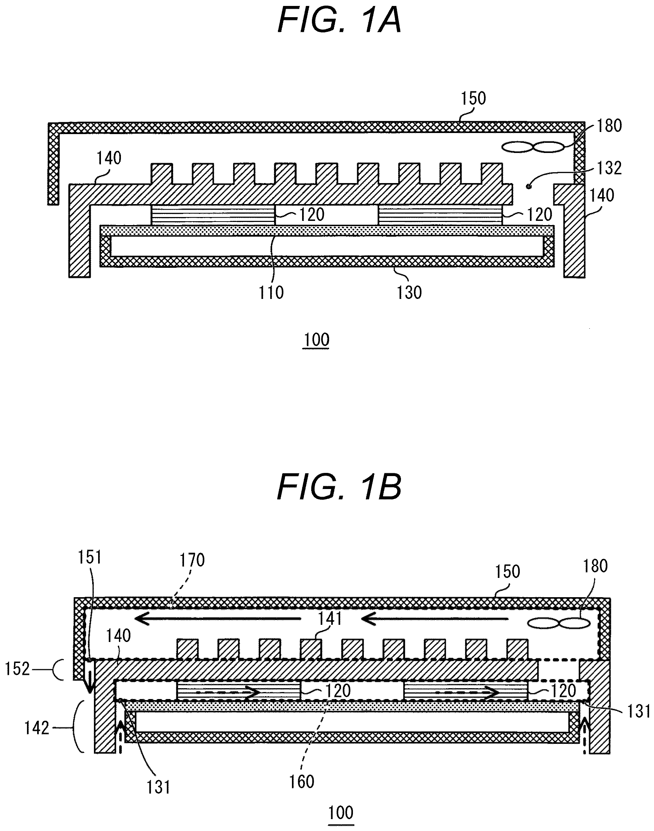

First, a cross-sectional configuration of an electronic apparatus according to a first embodiment will be described. FIGS. 1A and 1B are diagrams schematically illustrating an exemplary cross-sectional configuration of the electronic apparatus according to the first embodiment. Note that it is assumed that the electronic apparatus 100 according to this embodiment includes any electronic apparatus embedded with a printed circuit board or the like mounted with heat-radiating electronic components, such as an sound device amplifier mounted on a vehicle.

As illustrated in FIG. 1A, the electronic apparatus 100 includes a printed circuit board 110 mounted with heat-radiating electronic components 120, and a bottom cover member 130 that supports the printed circuit board 110 from the bottom.

In addition, the electronic apparatus 100 has a heat sink 140 that covers the printed circuit board 110 to form a first space with a gap from the printed circuit board 110.

The electronic apparatus 100 has an upper cover member 150 that covers the heat sink 140 to form a second space along with the heat sink 140.

In addition, the electronic apparatus 100 has a fan 180 installed in a through-hole 132 provided in a part of the heat sink 140.

As illustrated in FIG. 1B, the heat sink 140 of the electronic apparatus 100 according to this embodiment serves as a partitioning wall plate that partitions the internal space into the first and second spaces 160 and 170. In addition, the heat sink 140 is thermally connected to the electronic component 120 placed in the first space 160 to conduct the heat generated from the electronic component 120 so as to serve as a thermal conductor that dissipates heat to the second space 170 through the fins 141. More specifically, a portion of the heat sink 140 directly thermally connected to the electronic component 120 corresponds to the thermal conductor, and a plate-shaped portion extending from the surrounding of the thermal conductor corresponds to the partitioning wall plate.

As illustrated in FIG. 1B, the fan 180 takes the air from the outside of the electronic apparatus 100 into the first space 160 through the air inlet (first opening) 131 by blowing the air from the first space 160 to the second space 170 to cool the first space 160 (refer to the dotted arrow). In addition, the fan 180 discharges the hear inside the second space 170 heated by heat dissipation from the fins 141 to the outside of the electronic apparatus 100 through the air outlet (second opening) 151 by blowing the air from the first space 160 to the second space 170 (refer to the solid arrow line).

That is, by installing the fan 180 in the through-hole 132 that allows the first and second spaces 160 and 170 to communicate with each other and forming an air flow flowing from the outside, to the first space 160, to the second space 170, and to the outside, it is possible to cool both the first and second spaces 160 and 170.

Note that, as illustrated in FIG. 1B, the air inlet 131 of the electronic apparatus 100 is covered by the extension wall 142 extending from the heat sink 140, so that the external air is received by the first space 160 in an upward direction. As a result, using the electronic apparatus 100, it is possible to avoid dust from entering from the air inlet 131.

As illustrated in FIG. 1B, the air outlet 151 of the electronic apparatus 100 is covered by the extension wall 152 extending from the upper cover member 150, so that the air of the second space 170 is discharged to the outside in a downward direction. As a result, using the electronic apparatus 100, it is possible to avoid water or the like from intruding from the air outlet 151.

### <Exterior Configuration of Electronic Apparatus>

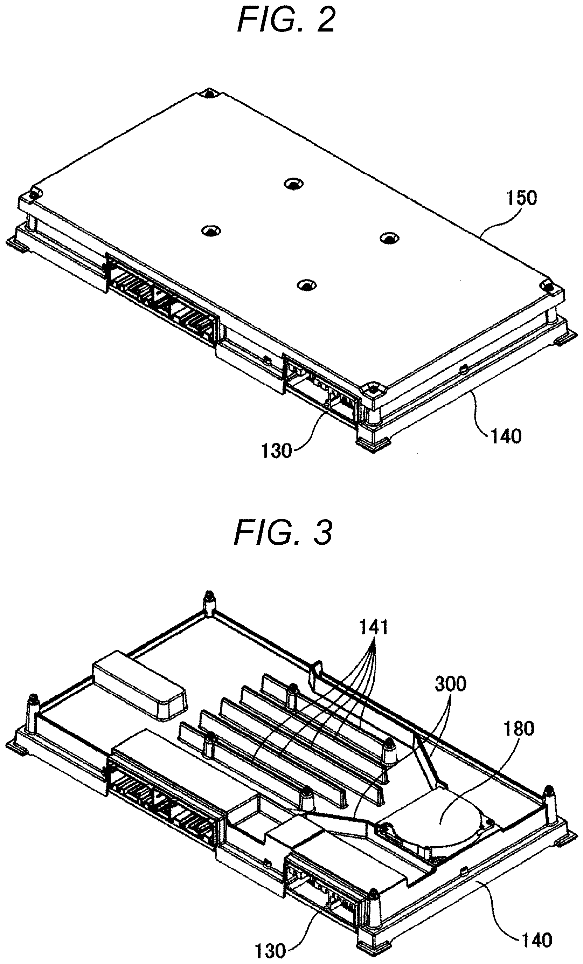

Next, an exterior configuration of the electronic apparatus 100 according to the first embodiment will be described with reference to FIGS. 2 to 4.

FIG. 2 is a diagram illustrating an exemplary exterior configuration of the electronic apparatus according to the first embodiment. As illustrated in FIG. 2, an upper cover member 150 is placed on top of the electronic apparatus 100, and the heat sink 140 is disposed under the upper cover member 150. In addition, a bottom cover member 130 is disposed under the heat sink 140.

FIG. 3 is a diagram illustrating a state in which the upper cover member is removed from the electronic apparatus according to the first embodiment.

As illustrated in FIG. 3, fins 141 protrude toward the second space 170 side from the heat sink 140 (between the heat sink 140 and the upper cover member 150). In addition, a flow guide 300 for guiding the air blowing from the fan 180 to the fins 141 is provided in the second space 170 side of the heat sink 140.

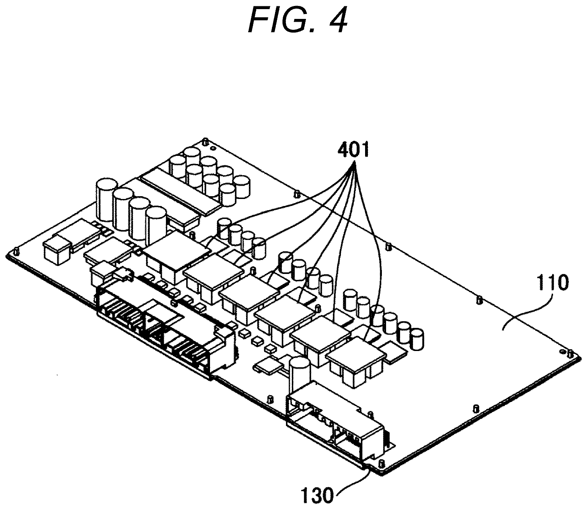

FIG. 4 is a diagram illustrating a state in which the upper cover member and the heat sink are removed from the electronic apparatus according to the first embodiment.

As illustrated in FIG. 4, a plurality of electronic components are disposed in the first space 160 side of the heat sink 140 (between the heat sink 140 and the printed circuit board 110 supported by the bottom cover member 130). The printed circuit board 110 is mounted with a plurality of electronic components, and a thermal conducting sheet 401 is installed on top of those of the electronic components that generate heat. In this manner, the heat-radiating ones of the electronic components mounted on the printed circuit board 110 are thermally connected to the heat sink 140 by interposing the thermal conducting sheet 401.

### <Configuration of Fan>

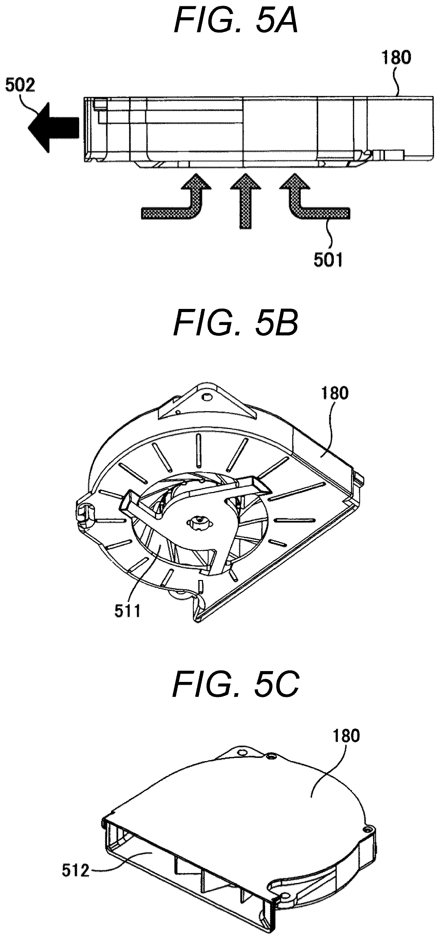

Next, a configuration of the fan 180 will be described. FIGS. 5A and 5B are diagrams illustrating an exemplary fan. FIG. 5A illustrates a side view of the fan 180. In the first embodiment, the fan 180 is a single-sided air inlet blower fan, which suctions the air from the bottom of the fan 180 in the arrow direction 501 and discharges the air from the side surface of the fan 180 in the arrow direction 502.

FIG. 5B illustrates the fan 180 as seen from the bottom. As illustrated in FIG. 5B, the bottom of the fan 180 is provided with an opening 511.

FIG. 5C illustrates the fan 180 as seen from the top. As illustrated in FIG. 5C, the side surface of the fan 180 is provided with an opening 512.

### <Air Flow in First Space>

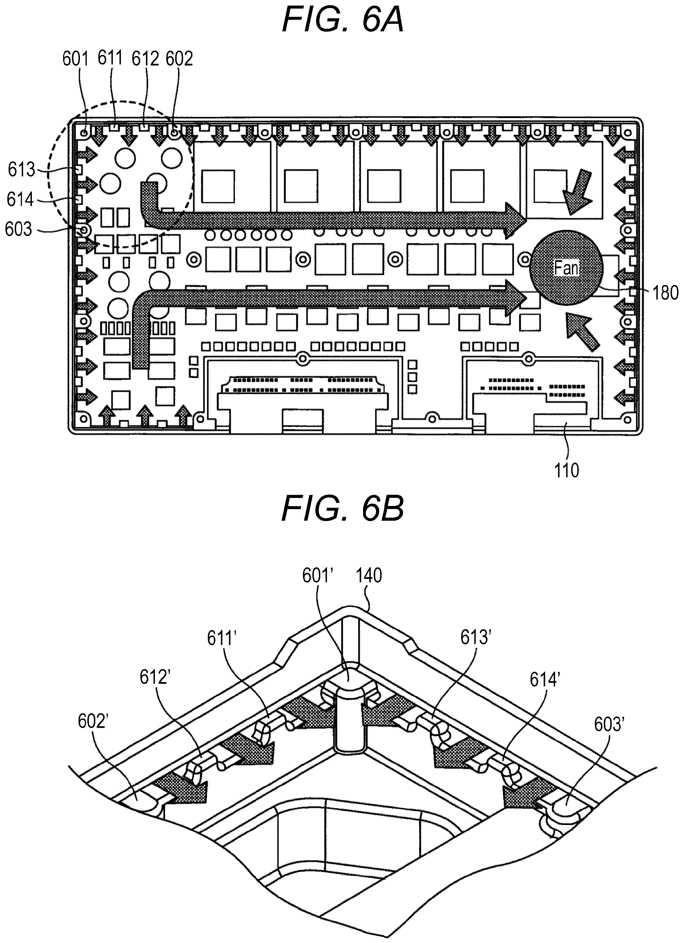

Next, a flow of the air in the first space 160 will be described on the basis of the configuration of the printed circuit board 110 and the configuration of the heat sink 140 in the first space 160. FIGS. 6A and 6B are diagrams illustrating exemplary configurations of the printed circuit board and the heat sink in the first space.

FIG. 6A is a top view illustrating the printed circuit board 110, in which a plurality of arrows on the printed circuit board 110 indicate flow directions of the air in the first space 160.

In the electronic apparatus 100 according to this embodiment, a plurality of air inlets 131 are provided along the outer circumference of the printed circuit board 110. For this reason, as illustrated in FIG. 6A, the air is taken to the first space 160 from a plurality of positions on the outer circumference of the printed circuit board 110.

FIG. 6B is a diagram illustrating a configuration of the air inlet 131. FIG. 6A illustrates a part of the heat sink 140 enclosed by the dotted circle in the printed circuit board 110 as seen from the surface side making contact with the printed circuit board 110. Engagement portions 601', 602', and 603' of the heat sink 140 are fixed to engagement portions 601, 602, and 603, respectively, of the printed circuit board 110 of FIG. 6A by vertically reversing the heat sink 140 of FIG. 6B and installing it in the printed circuit board 110. In addition, abutting portions 611', 612', 613', and 614' of the heat sink 140 abut on abutting portions 611, 612, 613, and 614, respectively, of the printed circuit board 110 of FIG. 6A.

As illustrated in FIG. 6B, in the electronic apparatus 100 according to this embodiment, the heat sink 140 is provided with concave portions between the engagement portion and the abutting portion and between the abutting portions. In addition, as the heat sink 140 is fixed to the printed circuit board 110, each of the concave portions forms an opening so as to serve as the air inlet 131. As a result, the air is taken from the outside of the electronic apparatus 100 to the first space 160 along the arrow direction of FIG. 6B.

In this manner, since the air is taken to the first space 160 from an arbitrary direction on the outer circumference of the printed circuit board 110, it is possible to cool the entire printed circuit board 110 in the electronic apparatus 100. In addition, since the flow velocity can be suppressed by reducing the amount of the air taken from each air inlet 131, it is possible to make it difficult to suction dust.

### <Air Flow in Second Space>

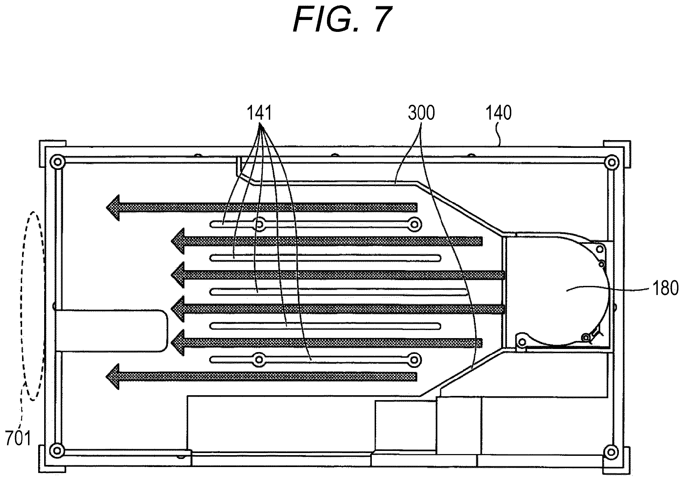

Next, a flow of the air in the second space will be described on the basis of the configuration of the heat sink 140 in the second space 170. FIG. 7 is a diagram illustrating an exemplary configuration of the heat sink in the second space.

As illustrated in FIG. 7, fins 141 protrude from the second space 170 side of the heat sink 140. In addition, a flow guide 300 for guiding the air blowing from the fan 180 to the fins 141 is provided in the second space 170 side of the heat sink 140.

Using this configuration, in the electronic apparatus 100, it is possible to allow the air to bump to the fins 141 in a concentrated manner by squeezing the air blowing from the fan 180 to increase its flow velocity.

As a result, it is possible to improve a cooling capability per unit area in the second space 170, compared to the first space.

Note that the air blowing from the fan 180 and bumping to the fins 141 in a concentrated manner is discharged to the outside of the electronic apparatus 100 from the air outlet 151 (for example, in the position indicated by the dotted line 701) provided between the upper cover member 150 and the heat sink 140.

### <Functional Effects>

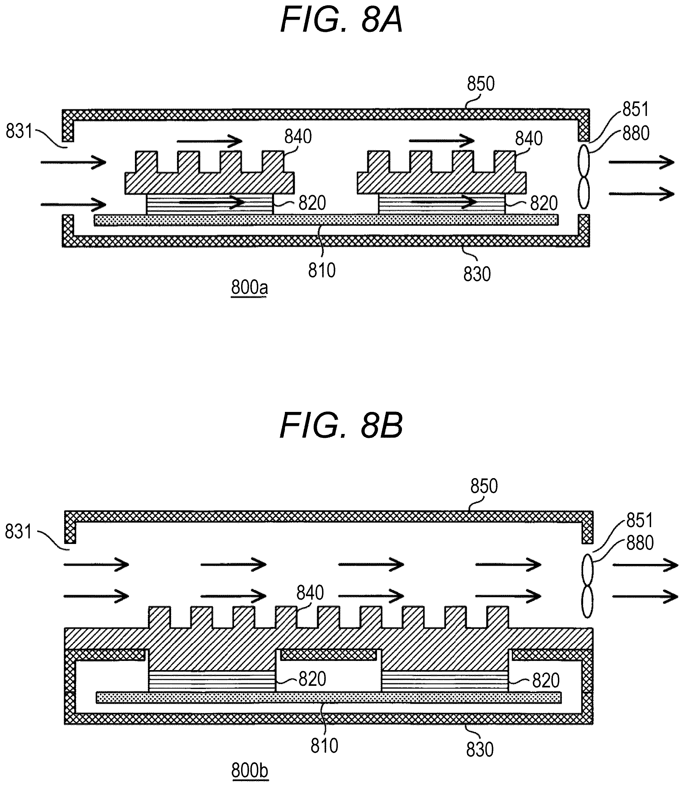

Next, functional effects (efficient cooling) of the electronic apparatus 100 according to the first embodiment will be described with reference to a comparative example. FIGS. 8A and 8B are diagrams schematically illustrating a cross-sectional configuration of the electronic apparatus of a comparative example.

FIG. 8A illustrates a cross-sectional configuration of an electronic apparatus 800a in which the air blows using a fan 880 to the entire electronic apparatus. In the case of FIG. 8A, a single space is formed by an upper cover member 850 and a bottom cover member 830 inside the electronic apparatus 800a. In the case of FIG. 8A, a printed circuit board 810 mounted with a heat-radiating electronic component 820 is placed in this single space, and a heat sink 840 is thermally connected to the electronic component 820.

In the electronic apparatus 800a of FIG. 8A, as the fan 880 operates, the air taken from the air inlet 831 blows to the heat sink 840 and the printed circuit board 810 evenly and is discharged from the air outlet 851.

Here, the amount of heat dissipating from the heat sink 840 is larger than the amount of heat dissipating from other electronic components of the printed circuit board 810. For this reason, even when the air blows to the heat sink 840 and the printed circuit board 810 evenly, it is difficult to efficiently cool the electronic apparatus 800a unless the air is sufficiently blown to the heat sink as necessary in the concentrated air blowing.

Meanwhile, FIG. 8B illustrates a cross-sectional configuration of the electronic apparatus 800b that performs air blowing using the fan 880 for the heat dissipation space by dividing the internal space of the electronic apparatus 800b into the heat dissipation space using the heat sink 840 and the space close to the printed circuit board 810.

As illustrated in FIG. 8B, if the internal space of the electronic apparatus 800b is divided into two spaces, and the air blowing is performed only for the heat dissipation space using the heat sink 840, it is possible blow the air to the heat sink 840 in a concentrated manner. For this reason, it is possible to efficiently cool the heat sink 840.

However, in the case of FIG. 8B, the air blowing is not performed for the space close to the printed circuit board 810. For this reason, cooling is not performed for a part of the electronic components mounted on the printed circuit board 810 and not thermally connected to the heat sink 840. Therefore, it is difficult to efficiently cool the electronic apparatus 800b as a whole.

In comparison, as described above, in the electronic apparatus 100 according to the first embodiment,
- the internal space of the electronic apparatus 100 is divided into the first space 160 where the printed circuit board 110 is placed and the second space 170 where heat dissipation is performed using the heat sink 140 thermally connected to the printed circuit board 110,
- the fan 180 is placed between the first and second spaces 160 and 170, and the air blows from the first space 160 to the second space 170, so that the air taken from the outside to the first space 160 is discharged to the outside via the second space 170, and
- the flow guide 300 is formed in the second space 170 such that the air blowing from the fan 180 is guided to the fins 141 of the heat sink 140.

For this reason, in the electronic apparatus 100 according to the first embodiment, it is possible to cool both the heat sink 140 (second space 170) thermally connected to the electronic component 120 and the electronic component (first space 160) that is not thermally connected to the heat sink 140. In addition, it is possible to blow the air to the heat sink 140 thermally connected to the electronic component 120 in a concentrated manner by increasing the flow velocity. That is, it is possible to cool two spaces using a single fan 180 by generating a difference in the cooling capability per unit area between the two spaces.

As a result, using the electronic apparatus 100 according to the first embodiment, it is possible to implement efficient cooling.

In addition, in the electronic apparatus 100 according to the first embodiment,
- a plurality of air inlets 131 for receiving the air in the first space 160 are placed in a plurality of positions on the outer circumference of the printed circuit board 110.

For this reason, in the electronic apparatus 100 according to the first embodiment, it is possible to cool the printed circuit board placed in the first space as a whole. Furthermore, it is possible to prevent dust from entering by suppressing the flow velocity of the air received in the first space 160.

In addition, in the electronic apparatus 100 according to the first embodiment,
- the extension wall 142 extends from the heat sink 140 to cover a plurality of air inlets 131, and
- the extension wall 152 extends from the upper cover member 150 to cover the air outlet 151.

For this reason, in the electronic apparatus 100 according to the first embodiment, it is possible to avoid dust from entering from the air inlet 131 or avoid water from intruding from the air outlet 151.

### [Second Embodiment]

In the first embodiment, a case where the first and second spaces 160 and 170 are arranged vertically has been described. However, the positional relationship between the first and second spaces 160 and 170 is not limited to the vertical direction, but may be arranged horizontally. In the second embodiment, a case where the first and second spaces 160 and 170 are arranged horizontally will be described by focusing on a difference from the first embodiment.

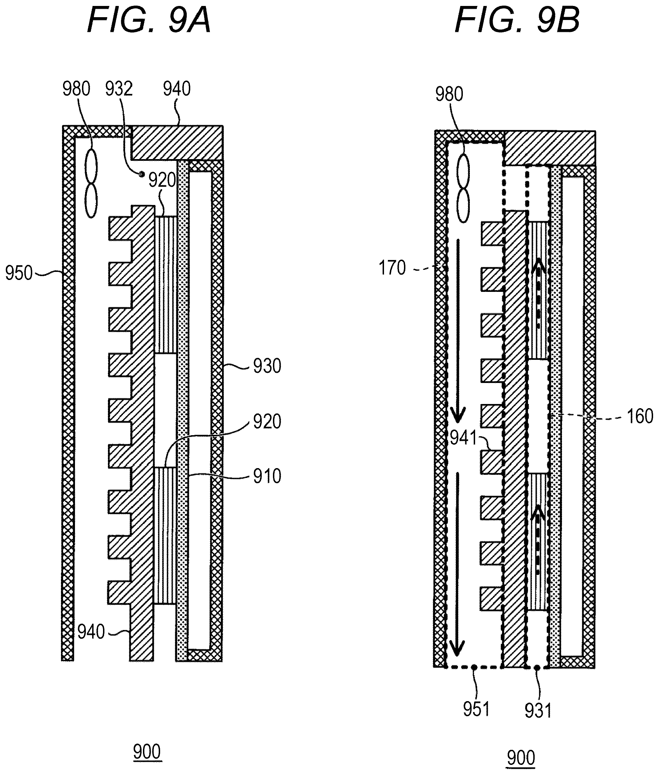

FIGS. 9A and 9B are diagrams schematically illustrating an exemplary cross-sectional configuration of an electronic apparatus according to the second embodiment. As illustrated in FIG. 9A, the electronic apparatus 900 according to the second embodiment has a printed circuit board 910 mounted with the heat-radiating electronic component 920 and a side cover member 930 that supports the printed circuit board 910 from the side surface.

The electronic apparatus 900 according to the second embodiment has a heat sink 940 to cover the printed circuit board 910 from the side surface and forms a first space along with the printed circuit board 910.

The electronic apparatus 100 has a side cover member 950 that covers the heat sink 940 from the side surface to form a second space along with the heat sink 940.

The electronic apparatus 900 has a fan 980 installed in a through-hole 932 provided in a part of the heat sink 940 to blow the air from the first space to the second space.

Even when the first and second spaces 160 and 170 are arranged horizontally as illustrated in FIG. 9B, the air enters from the outside of the electronic apparatus 900 to the first space 160 through the air inlet 931 as the fan 980 blows the air (refer to the dotted arrow). As a result, the first space 160 is cooled. In addition, the air in the second space 170 heated by heat dissipation from the fins 941 is discharged to the outside of the electronic apparatus 900 through the air outlet 951 as the fan 980 blows the air (refer to the solid arrow). As a result, the second space 170 is cooled.

In this configuration, even in the second embodiment, similar to the first embodiment, it is possible to efficiently cool the internal space of the electronic apparatus.

### [Third Embodiment]

In the first and second embodiments, the through-hole is provided in the heat sink serving as a partitioning wall plate that partitions the internal space into the first and second spaces, and the fan is installed in the through-hole, so that the air blows from the first space to the second space. However, the configuration for blowing the air from the first space to the second space is not limited thereto.

For example, the air may blow from the first space to the second space by providing a communication pipe that connects the first and second spaces outside the main body of the electronic apparatus 100 and installing the fan in the communication pipe.

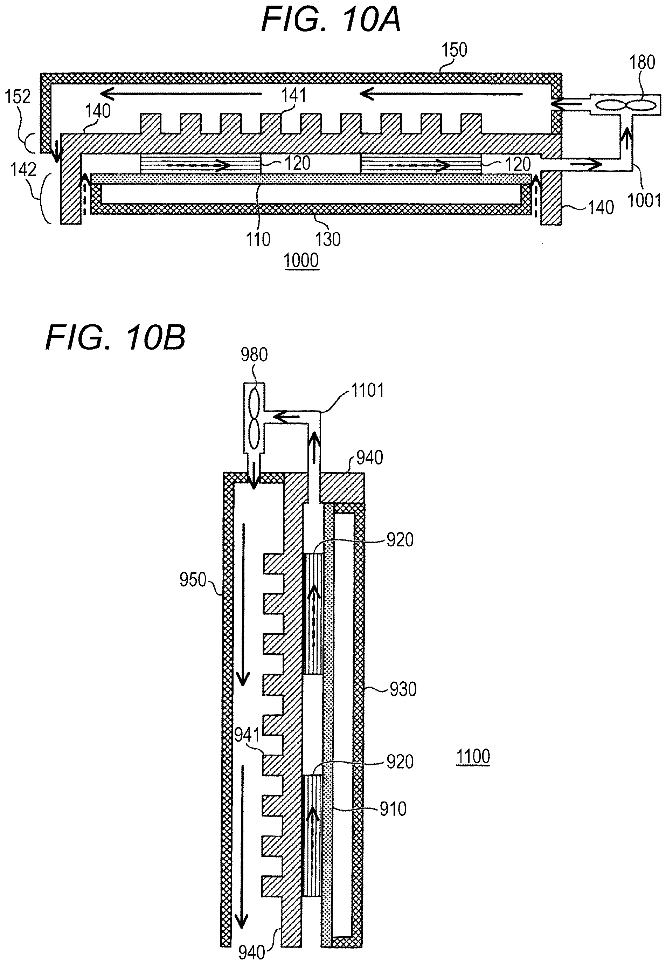

FIGS. 10A and 10B are diagrams schematically illustrating an exemplary cross-sectional configuration of the electronic apparatus according to the third embodiment. FIG. 10A is different from FIGS. 1A and 1B in that a communication pipe 1001 that allows the first and second spaces 160 and 170 to communicate with each other is disposed outside the main body of the electronic apparatus 1000, and the fan 180 is installed in the communication pipe 1001.

In this manner, even when the fan 180 is provided in the middle of the communication pipe that allows the first and second spaces 160 and 170 to communicate with each other and outside the main body of the electronic apparatus 1000, it is possible to achieve the same effects as those of the first embodiment. However, if the fan 180 is installed in the through-hole 132 of the heat sink 140 as in the first embodiment, it is possible to obtain an excellent soundproof effect compared to this embodiment.

Similarly, FIG. 10B is different from FIGS. 9A and 9B in that a communication pipe 1101 that allows the first and second spaces 160 and 170 to communicate with each other is disposed outside the main body of the electronic apparatus 1100, and the fan 980 is installed in the communication pipe 1101.

In this manner, even when the fan 980 is provided in the middle of the communication pipe that allows the first and second spaces 160 and 170 to communicate with each other and outside the main body of the electronic apparatus 1100, it is possible to achieve the same effects as those of the second embodiment. However, if the fan 980 is installed in the through-hole 932 of the heat sink 940 as in the second embodiment, it is possible to obtain an excellent soundproof effect compared to this embodiment.

### [Fourth Embodiment]

In the first to third embodiments, the heat sink 140 is employed as a partitioning wall plate for dividing the internal space into the first and second spaces. However, the member for dividing the internal space into the first and second spaces 160 and 170 is not limited to the heat sink, and any other member may also be employed.

In this case, the heat sink is disposed in the second space side of the partitioning wall plate, and the heat-radiating electronic component and the heat sink are thermally connected by interposing the partitioning wall plate.

That is, the partitioning wall plate that divides the internal space of the electronic apparatus into the first and second spaces may be formed integrally with the heat sink or may be formed separately. However, if the partitioning wall plate that divides the internal space into the first and second spaces 160 and 170 is formed integrally with the heat sink (that is, the first to third embodiments), it is possible to implement higher cooling efficiency advantageously.

In the first to third embodiments, the air blows from the first space to the second space. However, the air blowing direction of the fan is not limited thereto, and the air blowing may be performed from the second space to the first space. In this case, the air inlet described in the first to third embodiments serves as the air outlet of the fourth embodiment, and the air outlet described in the first to third embodiments serves as the air inlet of the fourth embodiment.

That is, the fan has a function of discharging the air entering into one of the spaces from the outside into the outside through the other space by blowing the air in a predetermined direction between the first and second spaces.

### Reference Signs List

100, 900, 1000, 1100: electronic apparatus
110, 910: printed circuit board
120, 920: electronic component
130: bottom cover member
131, 931: air inlet
140, 940: heat sink (thermal conductor, partitioning wall plate)
141, 941: fin
150: upper cover member
151, 951: air outlet
160: first space
170: second space
180, 980: fan
930, 950: side cover member
1001, 1101: communication pipe
300: flow guide
401: thermal conducting sheet

## Claims

1. An electronic apparatus **characterized by**:
a partitioning wall plate (140) that covers a board (110) mounted with an electronic component (120) and forms a first space (160) along with the board (110);
a cover member (150) that covers the partitioning wall plate (140) and forms a second space (170) along with the partitioning wall plate (140); and
a fan (180) configured to blow air entering from the outside to the first space (160) toward the outside through the second space (170) in a predetermined direction; and
the second space (170) is provided with a thermal conductor (140) thermally connected to an electronic component (120) of the first space (160), and a flow guide for guiding the air blowing from the fan (180) to the thermal conductor (140).

2. The electronic apparatus according to claim 1, **characterized in that** the partitioning wall plate (140) is formed integrally with the thermal conductor (140).

3. The electronic apparatus according to claim 1, **characterized in that** the first space (160) is provided with a plurality of first openings (131) along an outer circumference of the board (110).

4. The electronic apparatus according to claim 1, **characterized in that**
the partitioning wall plate (140) is provided with a through-hole (132) that allows the first and second spaces (160 and 170) to communicate with each other, and
the fan (180) is installed to the through-hole (132).

5. The electronic apparatus according to claim 3, **characterized in that** the partitioning wall plate (140) has an extension wall (142) that covers the plurality of first openings (131).

## Patentansprüche

1. Elektronische Vorrichtung, die durch Folgendes gekennzeichnet ist:
eine Trennwandplatte (140), die eine Platine (110) bedeckt, an der eine elektronische Komponente (120) montiert ist und die zusammen mit der Platine (110) einen ersten Raum (160) bildet;
ein Abdeckelement (150), das die Trennwandplatte (140) abdeckt und zusammen mit der Trennwandplatte (140) einen zweiten Raum (170) bildet; und
ein Gebläse (180), das dafür konfiguriert ist, von außen in den ersten Raum (160) eintretende Luft durch den zweiten Raum (170) in einer vorbestimmten Richtung nach außen zu blasen; und
wobei der zweite Raum (170) mit einem Wärmeleiter (140), der thermisch mit einer elektronischen Komponente (120) des ersten Raums (160) verbunden ist, und einer Strömungsführung zum Führen der Luft, die vom Gebläse (180) zum Wärmeleiter (140) bläst, versehen ist.

2. Elektronische Vorrichtung nach Anspruch 1, **dadurch gekennzeichnet, dass** die Trennwandplatte (140) einstückig mit dem Wärmeleiter (140) gebildet ist.

3. Elektronische Vorrichtung nach Anspruch 1, **dadurch gekennzeichnet, dass** der erste Raum (160) mit mehreren ersten Öffnungen (131) entlang eines Außenumfangs der Platine (110) versehen ist.

4. Elektronische Vorrichtung nach Anspruch 1, die **dadurch gekennzeichnet ist, dass**
die Trennwandplatte (140) mit einem Durchgangsloch (132) versehen ist, das es dem ersten und dem zweiten Raum (160 und 170) ermöglicht, miteinander zu kommunizieren, und
der Lüfter (180) in dem Durchgangsloch (132) installiert ist.

5. Elektronische Vorrichtung nach Anspruch 3, **dadurch gekennzeichnet, dass** die Trennwandplatte (140) eine Verlängerungswand (142) aufweist, die die mehreren ersten Öffnungen (131) abdeckt.

## Revendications

1. Appareil électronique **caractérisé par** :
une plaque formant paroi de séparation (140) qui recouvre une carte (110) sur laquelle est monté un composant électronique (120) et forme un premier espace (160) avec la carte (110) ;
un élément formant couvercle (150) qui recouvre la plaque formant paroi de séparation (140) et forme un deuxième espace (170) avec la plaque formant paroi de séparation (140) ; et
un ventilateur (180) configuré pour souffler de l'air entrant en provenance de l'extérieur jusque dans le premier espace (160) en direction de l'extérieur au travers du deuxième espace (170) dans une direction prédéterminée ; et
le deuxième espace (170) comporte un conducteur thermique (140) connecté de manière thermique à un composant électronique (120) du premier espace (160), et un dispositif de guidage d'écoulement servant à guider l'air qui souffle en provenance du ventilateur (180) jusqu'au conducteur thermique (140).

2. Appareil électronique selon la revendication 1, **caractérisé en ce que** la plaque formant paroi de séparation (140) est formée d'un seul tenant avec le conducteur thermique (140).

3. Appareil électronique selon la revendication 1, **caractérisé en ce que** le premier espace (160) comporte une pluralité de premières ouvertures (131) le long d'une circonférence extérieure de la carte (110).

4. Appareil électronique selon la revendication 1, **caractérisé en ce que**
la plaque formant paroi de séparation (140) comporte un trou traversant (132) qui permet aux premier et deuxième espaces (160 et 170) de communiquer l'un par rapport à l'autre, et
le ventilateur (180) est installé au niveau du trou traversant (132).

5. Appareil électronique selon la revendication 3, **caractérisé en ce que** la plaque formant paroi de séparation (140) a une paroi d'extension (142) qui recouvre la pluralité de premières ouvertures (131).
